# EUROPÄISCHE PATENTSCHRIFT

(11) **EP 3 106 005 B1**
(45) Veröffentlichungstag und Bekanntmachung des Hinweises auf die Patenterteilung: **04.04.2018**
(21) Anmeldenummer: 14704340.0
(22) Anmeldetag: 13.02.2014
(51) Int. Cl.: H05G 2/00, G02B 7/00, H01S 3/00

(54) **EINRICHTUNG UND VERFAHREN ZUM SCHUTZ EINER VAKUUM-UMGEBUNG VOR LECKAGE UND EUV-STRAHLUNGSERZEUGUNGSVORRICHTUNG**
DEVICE AND METHOD FOR PROTECTING A VACUUM ENVIRONMENT AGAINST LEAKAGE, AND EUV RADIATION-GENERATING APPARATUS
DISPOSITIF ET PROCÉDÉ POUR PROTÉGER UN ENVIRONNEMENT DE VIDE CONTRE LES FUITES, ET DISPOSITIF DE PRODUCTION D'UN RAYONNEMENT EUV

(43) Veröffentlichungstag der Anmeldung: 21.12.2016
(73) Patentinhaber: TRUMPF Laser-und Systemtechnik GmbH, 71254 Ditzingen (DE)
(72) Erfinder: ENZMANN, Andreas, 78052 Villingen-Schwenningen (DE); VOLZ, Björn, 71634 Ludwigsburg (DE)
(74) Vertreter: Kohler Schmid Möbus Patentanwälte
(86) Internationale Anmeldenummer: PCT/EP2014/052798
(87) Internationale Veröffentlichungsnummer: WO 2015/120889

(56) Entgegenhaltungen:
- WO-A1-88/04846
- WO-A1-2012/026228
- US-A1- 2009 086 917

## Beschreibung

Die vorliegende Erfindung betrifft eine Einrichtung zum Schutz einer Vakuum-Umgebung vor Leckage, umfassend eine optische Komponente, welche die Vakuum-Umgebung gasdicht abschließt, sowie eine Kühleinrichtung zum Kühlen der optischen Komponente durch Zuführen eines Kühlmediums zu einem gasdicht von der Vakuum-Umgebung getrennten Kühlbereich, in dem ein erster Teilbereich der optischen Komponente angeordnet ist. Die Erfindung betrifft auch eine EUV-Strahlungserzeugungsvorrichtung mit einer solchen Einrichtung. Die Erfindung betrifft weiterhin ein Verfahren zum Schutz einer Vakuum-Umgebung vor einer Leckage an einer optischen Komponente, welche die Vakuum-Umgebung gasdicht abschließt, umfassend: Zuführen eines Kühlmediums zu einem gasdicht von der Vakuum-Umgebung getrennten Kühlbereich, in dem ein erster Teilbereich der optischen Komponente angeordnet ist.

Eine solche Einrichtung sowie ein zugehöriges Verfahren sind in der WO 2012/026228 A1 beschrieben.

In der US 8,847,182 der Anmelderin ist eine EUV-Strahlungserzeugungsvorrichtung beschrieben, welche eine Vakuum-Kammer aufweist, in der zur Erzeugung von EUV-Strahlung ein Target-Material eingebracht werden kann. Eine Strahlführungs-Kammer dient zur Führung eines Laserstrahls von einer Laserquelle in die Vakuum-Kammer. Zwischen der Vakuum-Kammer und der Strahlführungs-Kammer ist eine Zwischen-Kammer angebracht. Ein die Zwischen-Kammer gasdicht abschließendes erstes Fenster dient zum Eintritt des Laserstrahls von der Strahlführungs-Kammer in die Zwischen-Kammer. Ein die Zwischen-Kammer gasdicht abschließendes zweites Fenster dient zum Austritt des Laserstrahls aus der Zwischen-Kammer in die Vakuum-Kammer.

Die Vakuum-Kammer wird durch das zweite Fenster dichtend von der Umgebung abgetrennt. Wird das zweite Fenster zerstört oder ist die Dichtung des zweiten Fensters fehlerhaft, kann Gas aus der Umgebung in die Vakuum-Kammer einströmen, da in der Vakuum-Kammer ein geringerer Druck als in der Umgebung, beispielsweise in der Strahlführung, herrscht. Das zweite Fenster bzw. dessen Abdichtung stellen somit potentielle Leckagequellen dar. Aufgrund eines undichten Fensters kann nicht nur Gas, sondern es können ggf. auch flüssige Stoffe, beispielsweise Kühlwasser zur Kühlung des Fensters in die Vakuum-Umgebung gelangen. In der US 8,847,182 wird vorgeschlagen, die primäre Abdichtung der Vakuum-Kammer durch das zweite Fenster um eine sekundäre Abdichtung durch das erste Fenster zu ergänzen, so dass bei einer Beschädigung oder einem Bruch des zweiten Fensters nur das in der Zwischen-Kammer vorhandene (kleine) Gasvolumen in die Vakuum-Umgebung gelangen kann.

Aus der WO 2011/130327 A1 ist eine Vorrichtung bekannt geworden, welche eine optische Komponente mit einer nicht-planaren Oberfläche aufweist, die einen optisch aktiven Bereich umfasst. Eine Strömungsführung ist zum Ausrichten eines Gases auf die nicht-planare Oberfläche ausgebildet, um zumindest in einem Teilbereich des optisch aktiven Bereichs der nicht-planaren Oberfläche der optischen Komponente eine turbulente Strömung zu erzeugen, um die optische Komponente zu kühlen. Bei der optischen Komponente kann es sich beispielsweise um eine konvexe Linse handeln, die zum Eintritt eines Laserstrahls in die Vakuum-Kammer einer EUV-Strahlungserzeugungsvorrichtung dient und die den Laserstrahl in einem Zielbereich innerhalb der Vakuum-Kammer fokussiert.

### Aufgabe der Erfindung

Der Erfindung liegt die Aufgabe zugrunde, eine Einrichtung und ein Verfahren zum verbesserten Schutz einer Vakuum-Umgebung vor Leckage an einer optischen Komponente sowie eine EUV-Strahlungserzeugungsvorrichtung mit einer solchen Einrichtung bereitzustellen.

### Gegenstand der Erfindung

Diese Aufgabe wird gelöst durch eine Einrichtung der eingangs genannten Art zum Schutz einer Vakuum-Umgebung vor Leckage, weiter umfassend: eine Unterdruckerzeugungseinrichtung zur Erzeugung eines Unterdrucks in einem gasdicht von der Vakuum-Umgebung und von dem Kühlbereich getrennten Unterdruckbereich, in dem ein zweiter Teilbereich der optischen Komponente angeordnet ist, sowie eine Detektionseinrichtung zur Detektion einer Leckage an der optischen Komponente beim Überströmen des Kühlmediums von dem Kühlbereich in den Unterdruckbereich und/oder in die Vakuum-Umgebung.

Unter einem Abschluss der Vakuum-Umgebung durch die optische Komponente wird im Sinne dieser Anmeldung verstanden, dass die optische Komponente die Vakuum-Umgebung, die typischer Weise in einer Vakuum-Kammer gebildet ist, von einem umgebenden Raum gasdicht trennt, der sich beispielsweise in einer weiteren Kammer befinden kann und in dem ein höherer Druck als in der Vakuum-Kammer herrscht. Der umgebende Raum ist in der Regel sowohl von dem Unterdruckbereich als auch von dem Kühlbereich gasdicht getrennt. Der Kühlbereich weist typischer Weise eine Einlassöffnung für das Kühlmedium sowie eine Austrittsöffnung für das Kühlmedium auf, d.h. es findet ein Austausch des Kühlmediums statt.

Bei einem Defekt an der optischen Komponente, beispielsweise einer Rissbildung, kann das flüssige oder gasförmige Kühlmedium von dem Kühlbereich über den Riss bzw. Defekt an der optischen Komponente in den Unterdruckbereich gelangen, d.h. der erste und zweite Teilbereich der optischen Komponente sind nicht mehr gasdicht voneinander getrennt. Bei dem Unterdruck handelt es sich um einen Druck, der kleiner ist als Atmosphärendruck bei Normalbedingungen. Der Unterdruckbereich bildet ein separates Vakuum, d.h. dieser ist nicht mit der Vakuum-Kammer bzw. mit der Vakuum-Umgebung verbunden. In dem Unterdruckbereich kann das Kühlmedium abgeführt bzw. abgesaugt werden, so dass dieses nicht in die Vakuum-Umgebung gelangt. Wird ein Überströmen des Kühlmediums von dem Kühlbereich in den Unterdruckbereich und/oder in die Vakuum-Umgebung detektiert, können Gegenmaßnahmen eingeleitet werden, die ein Eindringen des Kühlmediums bzw. größerer Mengen des Kühlmediums in die Vakuum-Umgebung verhindern. Der zweite Teilbereich der optischen Komponente, welcher in dem Unterdruckbereich angeordnet ist, befindet sich typischer Weise auf der der Vakuum-Umgebung abgewandten Seite der optischen Komponente.

Bei einer Ausführungsform ist die Einrichtung ausgebildet, bei einer Leckage an der optischen Komponente eine Zuführungsleitung zur Zuführung des Kühlmediums zu dem Kühlbereich zu sperren. Auf diese Weise kann verhindert werden, dass weiteres Kühlmedium über die Einlassöffnung in den Kühlbereich nachströmt, das ansonsten in die Vakuum-Umgebung gelangen könnte. Das Sperren der Zuführungsleitung kann beispielsweise über ein schaltbares Ventil, z.B. ein Wegeventil, erfolgen, welches von der Detektionseinheit in eine geeignete Schaltstellung geschaltet wird.

Bei einer weiteren Ausführungsform ist die Einrichtung ausgebildet, bei einer Leckage an der optischen Komponente dem Kühlbereich ein typischer Weise gasförmiges Spülmedium zuzuführen. Durch die Spülung des Kühlbereichs mittels eines für die in der Vakuum-Umgebung angeordneten Komponenten inerten Mediums, typischer Weise eines Spülgases, insbesondere eines Edelgases, z.B. Argon, oder ggf. von Wasserstoff unmittelbar nach der Detektion der Leckage kann das Kühlmedium aus dem Kühlbereich entfernt werden, so dass die in der Vakuum-Umgebung befindlichen optischen Komponenten vor Verschmutzung oder Beschädigung durch das Kühlmedium geschützt werden. Das Spülen mit dem Spülmedium erfolgt typischer Weise unter Druck, um das Kühlmedium möglichst schnell auszuspülen. Es versteht sich, dass das Spülen mit dem Spülmedium zeitlich begrenzt erfolgt, und zwar typischer Weise so lange, bis das Kühlmedium vollständig aus dem Kühlbereich entfernt wurde.

Bei einer Weiterbildung ist die Einrichtung ausgebildet, dem Kühlbereich das Spülmedium über eine Austrittsöffnung oder eine Eintrittsöffnung für das Kühlmedium zuzuführen. Ein Spülen des Kühlbereichs im Gegenstrom-Prinzip, d.h. entgegen der Strömungsrichtung des Kühlmediums, hat sich als vorteilhaft erwiesen, das Spülmedium kann dem Kühlbereich aber auch über die Eintrittsöffnung für das Kühlmedium oder ggf. über eine weitere Öffnung zugeführt werden.

Bei einer Weiterbildung weist die Einrichtung ein schaltbares Ventil zur wahlweisen Verbindung der Austrittsöffnung mit einer Zuführungsleitung für das Spülgas oder einer Abführungsleitung für das Kühlmedium auf. Das Ventil kann in diesem Fall von einer ersten Schaltstellung (Kühlbetrieb), in dem die Abführungsleitung für das Kühlmedium mit der Austrittsöffnung verbunden ist, in eine zweite Schaltstellung umgeschaltet werden, in der die Zuführungsleitung mit der Austrittsöffnung verbunden ist (Spülbetrieb). Die Umschaltung vom Kühlbetrieb in den Spülbetrieb erfolgt, wenn die Detektionseinrichtung eine Leckage an der optischen Komponente detektiert. Alternativ kann ein schaltbares Ventil vorgesehen sein, um wahlweise eine Verbindung einer Eintrittsöffnung des Kühlbereichs für das Kühlmedium mit einer Zuführungsleitung für das Kühlmedium oder mit einer Zuführungsleitung für das Spülmedium herzustellen, um zwischen dem Kühlbetrieb und dem Spülbetrieb umzuschalten.

Bei einer weiteren Ausführungsform ist die Einrichtung ausgebildet, zur Absaugung des Spülmediums aus dem Kühlbereich eine Fluidverbindung zwischen dem Kühlbereich und der Unterdruckerzeugungseinrichtung herzustellen. Auf diese Weise kann das Spülmedium besonders effektiv aus dem Kühlbereich abgesaugt werden. Insbesondere können auch Restmoleküle, die nach dem Spülvorgang im Leitungssystem zurückgeblieben sind, von der Unterdruckerzeugungseinrichtung abgesaugt werden.

Bei einer vorteilhaften Weiterbildung weist die Einrichtung ein schaltbares Ventil zum wahlweisen Verbinden einer Einlassöffnung des Kühlbereichs mit einer Zuführungsleitung für das Kühlmedium oder mit einer Verbindungsleitung zur Verbindung mit der Unterdruckerzeugungseinrichtung auf. Das schaltbare Ventil kann ggf. in einer baulichen Einheit mit dem weiter oben beschriebenen schaltbaren Ventil realisiert werden. Das schaltbare Ventil kann insbesondere federbeaufschlagt sein, d.h. dieses weist im unbestromten Zustand eine definierte Ventillage bzw. Schaltstellung auf. Die Schaltstellung im unbestromten Zustand dient typischer Weise dem Kühlbetrieb. Das schaltbare Ventil wird in diesem Fall erst mit Strom beaufschlagt und elektrisch in die Schaltstellung für den Spülbetrieb umgeschaltet, wenn eine Leckage detektiert wird.

Alternativ kann die Einrichtung ein schaltbares Ventil zur wahlweisen Verbindung der Austrittsöffnung des Kühlbereichs mit einer Abführungsleitung für das Kühlmedium oder mit einer Verbindungsleitung zur Verbindung mit der Unterdruckerzeugungseinrichtung aufweisen. Auch ein solches Ventil kann federbeaufschlagt sein, wobei die Schaltstellung des Ventils im unbestromten Zustand typischer Weise dem Kühlbetrieb dient.

Bei einer vorteilhaften Weiterbildung weist die Detektionseinrichtung einen Drucksensor zur Bestimmung eines von der Unterdruckerzeugungseinrichtung erzeugten (Unter-)drucks und/oder einen Drucksensor zur Bestimmung eines Drucks in der Vakuum-Umgebung auf. Der Drucksensor ist zur Messung eines Drucks bzw. einer zeitlichen Druckänderung, insbesondere eines Druckanstiegs, ausgebildet, der in dem Unterdruckbereich bzw. in einer zwischen der Unterdruckerzeugungseinrichtung und dem Unterdruckbereich bzw. einer Eintrittsöffnung des Unterdruckbereichs gebildeten Leitung bzw. in der Vakuum-Umgebung herrscht.

Bei einer Weiterbildung ist die Detektionseinrichtung ausgebildet, beim Überschreiten eines Druck-Schwellwerts des Unterdrucks und/oder des Drucks in der Vakuum-Umgebung oder beim Überschreiten eines Schwellwerts eines Druckanstiegs des Unterdrucks und/oder des Drucks in der Vakuum-Umgebung ein Überströmen des Kühlmediums von dem Kühlbereich in den Unterdruckbereich zu detektieren. Durch den Übertritt des Kühlmediums steigt der von dem Drucksensor detektierte Druck typischer Weise an. Liegt der von dem Drucksensor detektierte Druck oder der Druckanstieg, d.h. die Druckänderung pro Zeiteinheit (Steigung), oberhalb eines Schwellwerts, wird dies an die Detektionseinrichtung oder ggf. an eine Steuereinrichtung gemeldet, welche die entsprechenden Maßnahmen vornimmt, um die Einrichtung vom Kühlbetrieb in den Spülbetrieb umzuschalten (s.o.).

Bei einer weiteren Ausführungsform weist die Detektionseinrichtung einen Restgasanalysator zur Detektion des Kühlmediums in der Vakuum-Umgebung auf. Der Restgasanalysator weist typischer Weise ein Massenspektrometer auf, um die Restgasatmosphäre in der Vakuum-Umgebung bzw. in der Vakuum-Kammer qualitativ und quantitativ zu analysieren. Die Detektion von Molekülen des Kühlmediums, beispielsweise von Wassermolekülen, kann darauf hindeuten, dass ein Übertritt des Kühlmediums in die Vakuum-Umgebung vorliegt.

Bei einer Weiterbildung ist der Restgasanalysator ausgebildet, beim Überschreiten eines Schwellwerts für den Partialdruck des Kühlmediums in der Vakuum-Umgebung oder beim Überschreiten eines Schwellwerts eines Anstiegs des Partialdrucks des Kühlmediums in der Vakuum-Umgebung ein Überströmen des Kühlmediums von dem Kühlbereich in die Vakuum-Umgebung zu detektieren. Der Restgasanalysator erzeugt typischer Weise ein Massenspektrum, anhand dessen die Anzahl der Moleküle von in der Vakuum-Umgebung enthaltenen Stoffen, genauer gesagt die Anzahl der Moleküle eines für den jeweiligen Stoff charakteristischen Masse-zu-Ladungs-Verhältnisses bestimmbar ist. Die Anzahl der Moleküle eines jeweiligen Stoffes ist typischer Weise proportional zum Partialdruck dieses Stoffes in der Vakuum-Umgebung und kann daher dazu dienen, um festzustellen, ob das Kühlmedium in die Vakuum-Umgebung übergetreten ist. Sofern ein geringer Anteil eines mit dem Kühlmedium identischen Stoffes, z.B. Wasserdampf, ohnehin, d.h. ohne das Vorliegen einer Leckage, in der Vakuum-Umgebung vorhanden ist, kann es günstig sein, das Vorliegen einer Leckage anhand des Überschreitens eines Schwellwerts des Anstiegs des Partialdrucks (d.h. der Änderung des Partialdrucks pro Zeiteinheit) zu detektieren.

Bei einer weiteren Ausführungsform umfasst die Einrichtung zusätzlich eine Halteeinrichtung zur Halterung der optischen Komponente, in welcher der

Kühlbereich und der Unterdruckbereich gebildet sind. Bei der Halteeinrichtung kann es sich insbesondere um eine Fassung handeln, in welche die optische Komponente eingesetzt ist. Sowohl der erste Teilbereich als auch der zweite Teilbereich können in Form von Hohlräumen in der Halteeinrichtung bzw. in der Fassung ausgebildet sein, welche durch die in die Halteeinrichtung eingesetzte optische Komponente sowie ggf. mit Hilfe von zusätzlichen Dichtungen gasdicht voneinander getrennt werden. Sowohl der erste als auch der zweite Teilbereich befinden sich typischer Weise in dem von der Fassung aufgenommenen Abschnitt der optischen Komponente, d.h. außerhalb eines optisch genutzten Teilbereichs der optischen Komponente.

Bei einer weiteren Ausführungsform umfasst die Einrichtung zusätzlich mindestens eine Dichtung zur gasdichten Trennung des Kühlbereichs von dem Unterdruckbereich. Die mindestens eine Dichtung ist zwischen dem Kühlbereich und dem Unterdruckbereich angeordnet und dient dazu, einen zwischen der optischen Komponente und der Halteeinrichtung ggf. vorhandenen Spalt gasdicht zu verschließen, so dass das Kühlmedium bei intakter optischer Komponente nicht von dem Kühlbereich in den Unterdruckbereich gelangen kann. Die Dichtung kann beispielsweise als O-Ring, als Formdichtung etc. ausgebildet sein. Die Einrichtung bzw. die Fassung kann mindestens eine weitere Dichtung aufweisen, die zwischen dem Unterdruckbereich und dem optisch genutzten Teilbereich der optischen Komponente angeordnet ist und die dazu dient, den Unterdruckbereich gasdicht von der Vakuum-Umgebung bzw. von dem die optische Komponente umgebenden Raum zu trennen.

Die Unterdruckerzeugungseinrichtung kann als Venturi-Düse ausgebildet sein. In einer Venturi-Düse wird der Unterdruck in einem Abnehmerrohr erzeugt, welches typischer Weise an der engsten Stelle eines Rohres angeordnet ist, durch welches ein Druckmedium, typischer Weise eine Flüssigkeit, z.B. Wasser, fließt. An der engsten Stelle des Rohres ist der statische Druck minimal, so dass in dem Abnehmerrohr ein Unterdruck entsteht, der zum Ansaugen eines flüssigen oder gasförmigen Mediums genutzt werden kann und der im vorliegenden Fall zum Ansaugen des Kühlmediums bzw. des Spülmediums dient. Es versteht sich, dass ggf. auch andere Unterdruckerzeugungseinrichtungen verwendet werden können, um in dem Unterdruckbereich einen Unterdruck zu erzeugen, beispielsweise

Absaug-Pumpen oder dergleichen.

Bei einer weiteren Ausführungsform weist die optische Komponente einen optisch genutzten Teilbereich auf und der erste Teilbereich ist weiter von dem optisch genutzten Teilbereich entfernt als der zweite Teilbereich. Dies ist günstig, da bei einer Rissbildung in der optischen Komponente das Kühlmedium vor dem Erreichen des optisch genutzten Teilbereichs zunächst zu dem zweiten Teilbereich gelangt und von der Unterdruckerzeugungseinrichtung abgesaugt werden kann. Der zweite Teilbereich kann insbesondere ringförmig ausgebildet sein, so dass ggf. aus dem Kühlbereich austretendes Kühlwasser unabhängig von der Art der Rissbildung in den zweiten Teilbereich gelangen kann.

Die optische Komponente kann als planparallele Platte bzw. als Fenster ausgebildet sein, d.h. die optische Komponente hat keine strahlformende Funktion. Wie weiter oben beschrieben wurde, kann durch ein solches Fenster ein Laserstrahl in die Vakuum-Umgebung eintreten. Aufgrund seiner hohen Wärmeleitfähigkeit wird als Material für ein solches Fenster insbesondere bei der Verwendung der Einrichtung in einer EUV-Strahlungserzeugungsvorrichtung mit hohen Laserleistungen (> 1 kW) häufig (künstlich hergestellter) Diamant verwendet. Die Herstellungskosten für ein solches Fenster aus Diamant-Material sind vergleichsweise hoch, so dass die Dicke eines solchen Fensters im Allgemeinen nicht zu groß gewählt wird. Bei der Verwendung eines Fensters mit vergleichsweise großer Dicke kann eine unzureichende Kühlung zudem eine Zerstörung des Diamant-Materials (Abbrand) zur Folge haben.

Ein weiterer Aspekt der Erfindung betrifft eine EUV-Strahlungserzeugungsvorrichtung, umfassend: eine Vakuum-Kammer mit einer Vakuum-Umgebung, in der zur Erzeugung von EUV-Strahlung ein Target-Material anordenbar ist, sowie eine Einrichtung wie oben beschrieben. Die optische Komponente dient in diesem Fall zur gasdichten Trennung der Vakuum-Umgebung in der Vakuum-Kammer von einer weiteren Kammer, beispielsweise einer Strahlführungs-Kammer, oder einer Zwischen-Kammer, wie sie in der eingangs erwähnten US 8,847,182 beschrieben ist. Die Strahlführungs-Kammer dient der Führung eines Laserstrahls von einer Strahlquelle, die beispielsweise einen oder mehrere CO₂-Laser aufweisen kann, in die Vakuum-Kammer. Der Laserstrahl wird in einem in der Vakuum-Kammer befindlichen Zielbereich fokussiert, an dem das Target-Material angeordnet ist.

Die Erfindung betrifft auch ein Verfahren der eingangs genannten Art zum Schutz einer Vakuum-Umgebung vor einer Leckage an einer optischen Komponente, welche die Vakuum-Umgebung gasdicht abschließt, weiter umfassend die Schritte: Erzeugen eines Unterdrucks in einem gasdicht von der Vakuum-Umgebung und von dem Kühlbereich getrennten Unterdruckbereich, in dem ein zweiter Teilbereich der optischen Komponente angeordnet ist, sowie Detektieren einer Leckage an der optischen Komponente beim Überströmen des Kühlmediums von dem Kühlbereich in den Unterdruckbereich. Wie weiter oben beschrieben wurde, kann das Überströmen beispielsweise anhand einer Erhöhung des Drucks in dem Unterdruckbereich bzw. in mit diesem verbundenen Leitungen detektiert werden.

Bei einer Variante wird nach dem Detektieren der Leckage das Zuführen des Kühlmediums zu dem Kühlbereich unterbunden, um ein Eindringen des Kühlmediums über die optische Komponente in die Vakuum-Umgebung zu vermeiden.

Bei einer weiteren Variante wird nach dem Detektieren der Leckage dem Kühlbereich ein Spülmedium zugeführt. Das Spülmedium ist für die in der Vakuum-Umgebung angeordneten optischen Komponenten typischer Weise inert, d.h. dieses führt nicht zu einer Beschädigung bzw. Verschmutzung dieser Komponenten.

Bei einer Weiterbildung wird zum Absaugen des Spülmediums aus dem Kühlbereich eine Fluidverbindung zwischen dem Kühlbereich und einer Unterdruckerzeugungseinrichtung hergestellt, um das Spülmedium aus dem Kühlbereich abzusaugen. Mit Hilfe der Unterdruckerzeugungseinrichtung können auch Restmoleküle abgesaugt werden, die nach dem Ausspülvorgang im Leitungssystem zurückgeblieben sind. Das ausgespülte Kühlmedium bzw. Spülmedium kann aufgefangen werden.

Weitere Vorteile der Erfindung ergeben sich aus der Beschreibung und der Zeichnung. Ebenso können die vorstehend genannten und die noch weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Es zeigen:

- Fig. 1: eine schematische Darstellung einer EUV-Strahlungserzeugungsvorrichtung, welche eine Strahlführungs-Kammer und eine Vakuum-Kammer sowie eine optische Komponente zur gasdichten Trennung der beiden Kammern aufweist,
- Fig. 2a: eine Darstellung einer Einrichtung zum Schutz einer in der Vakuum-Kammer gebildeten Vakuum-Umgebung vor einer Leckage der optischen Komponente während eines Kühlbetriebs,
- Fig. 2b: eine Darstellung der Einrichtung von Fig. 2a während eines Spülbetriebs, und
- Fig. 3a,b: Darstellungen analog Fig. 2a,b mit einer im Vergleich zu Fig. 2a,b umgekehrten Flussrichtung eines Kühlmediums.

In der folgenden Beschreibung der Zeichnungen werden für gleiche bzw. funktionsgleiche Bauteile identische Bezugszeichen verwendet.

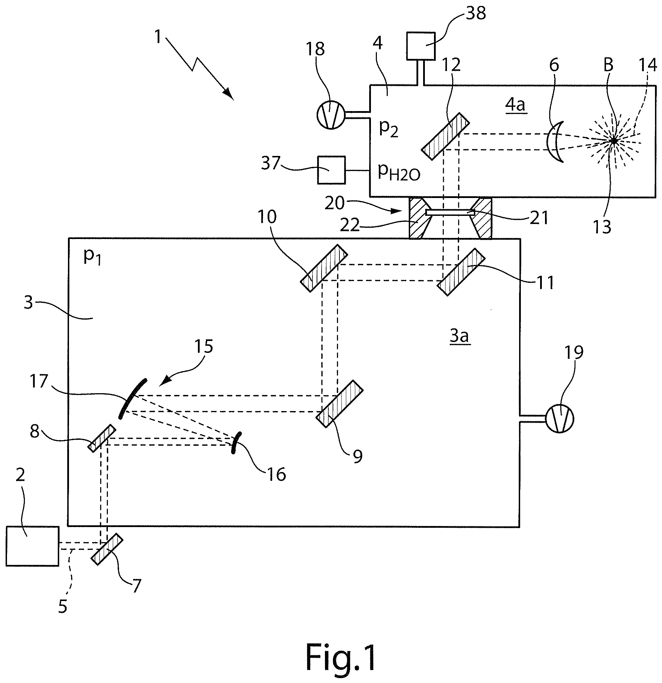

**Fig. 1** zeigt eine EUV-Strahlungserzeugungsvorrichtung 1, welche eine Treiberlasereinrichtung 2, eine Strahlführungs-Kammer 3 sowie eine Vakuum-Kammer 4 aufweist. In einer in der Vakuum-Kammer 4 gebildeten Vakuum-Umgebung 4a ist eine Fokussiereinrichtung in Form einer Fokussierlinse 6 angeordnet, um einen CO₂-Laserstrahl 5 in einem Zielbereich B zu fokussieren. Die in Fig. 1 gezeigte EUV-Strahlungserzeugungsvorrichtung 1 entspricht im Wesentlichen dem Aufbau, wie er in der US 2011/0140008 A1 beschrieben ist, die durch Bezugnahme zum Inhalt dieser Anmeldung gemacht wird. Auf die Darstellung von Messeinrichtungen zur Überwachung des Strahlengangs des Laserstrahls 5 wurde aus Gründen der Übersichtlichkeit verzichtet.

Die Treiberlasereinrichtung 2 umfasst eine CO₂-Strahlquelle sowie mehrere Verstärker zur Erzeugung eines Laserstrahls 5 mit hoher Strahlungsleistung (> 1 kW). Für eine detaillierte Beschreibung von Beispielen für mögliche Ausgestaltungen der Treiberlasereinrichtung 2 sei auf die US 2011/0140008 A1 verwiesen. Von der Treiberlasereinrichtung 2 wird der Laserstrahl 5 über einer Mehrzahl von Umlenkspiegeln 7 bis 11 der Strahlführungs-Kammer 3 sowie eines weiteren Umlenkspiegels 12 in der Vakuum-Kammer 4 auf die Fokussierlinse 6 umgelenkt, welche den Laserstrahl 5 in dem Zielbereich B fokussiert, an dem Zinn als Target-Material 13 angeordnet ist.

Das Target-Material 13 wird von dem fokussierten Laserstrahl 5 getroffen und hierbei in einen Plasma-Zustand übergeführt, der zur Erzeugung von EUV-Strahlung 14 dient. Das Target-Material 13 wird dem Zielbereich B mit Hilfe einer (nicht gezeigten) Bereitstellungseinrichtung zugeführt, welche das Target-Material 13 entlang eines vorgegebenen Pfades führt, der den Zielbereich B kreuzt. Für Details der Bereitstellung des Ziel-Materials sei ebenfalls auf die US 2011/0140008 A1 verwiesen.

In einem Strahlführungs-Raum 3a der Strahlführungs-Kammer 3 ist eine Einrichtung 15 zur Vergrößerung eines Strahldurchmessers des Laserstrahls 5 vorgesehen, welche einen ersten Off-Axis Parabolspiegel 16 mit einer ersten, konvex gekrümmten reflektierenden Oberfläche und einen zweiten Off-Axis Parabolspiegel 17 mit einer zweiten, konkav gekrümmten reflektierenden Oberfläche aufweist. Die reflektierenden Oberflächen eines Off-Axis Parabolspiegels 16, 17 bilden jeweils die Off-Axis Segmente eines (elliptischen) Paraboloids. Der Begriff "Off-Axis" bedeutet, dass die reflektierenden Oberflächen nicht die Rotationsachse des Paraboloids (und damit auch nicht den Scheitelpunkt des Paraboloids) enthalten.

Eine Vakuum-Pumpe 18 dient der Erzeugung eines Betriebsdrucks p₂ in der Vakuum-Kammer 4, der im Feinvakuum-Bereich (in der Regel bei deutlich weniger als 1,0 mbar) liegt. Der Betrieb der Vakuum-Kammer 4 unter Vakuum-Bedingungen ist erforderlich, da es in einer Restgas-Umgebung mit zu hohem Druck zu einer zu starken Absorption der erzeugten EUV-Strahlung 14 kommen würde. Demgegenüber wird die Strahlführungs-Kammer 3 bzw. der in dieser gebildete Innenraum 3a mit einem deutlich höheren Druck p₁ betrieben, der beispielsweise in der Größenordnung von ca. 5 mbar über Atmosphärendruck (1013 mbar) liegen kann. Die Strahlführungs-Kammer 3 wird somit gezielt gegenüber der Umgebung der EUV-Strahlerzeugungsvorrichtung 1 unter einen Überdruck gesetzt, um die optischen Elemente, die in der Strahlführungs-Kammer 3 angeordnet sind, vor Verschmutzungen zu schützen.

In Fig. 1 ebenfalls zu erkennen ist eine Einrichtung 20 zum Schutz der Vakuum-Umgebung 4a in der Vakuum-Kammer 4 vor Leckage an einer optischen Komponente 21 in Form einer Planplatte bzw. eines Fensters, welche zum gasdichten Abschluss der Vakuum-Umgebung 4a bzw. zur gasdichten Trennung der Vakuum-Kammer 4 und der Strahlführungs-Kammer 3 dient. Das Fenster 21 ist in eine Fassung 22 integriert. Durch das Fenster 21 kann der Laserstrahl 5 in die Vakuum-Umgebung 4a eintreten. Das Material des Fensters 21, im vorliegenden Beispiel (künstlich hergestellter) Diamant, wird aufgrund der hohen Strahlungsleistung des Laserstrahls 5 stark erwärmt.

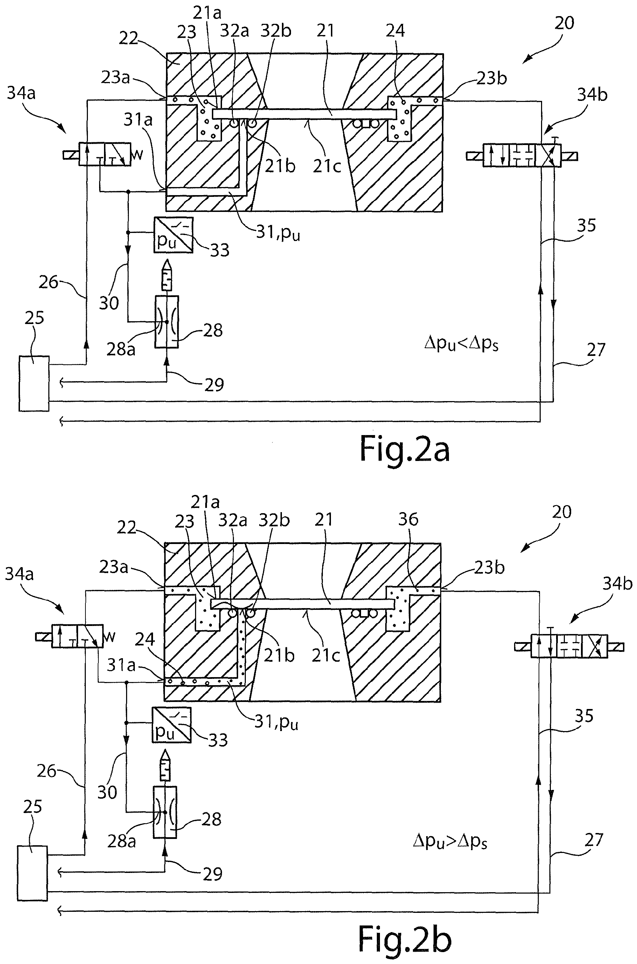

Wie in **Fig. 2a** zu erkennen ist, weist die Fassung 22 einen Hohlraum auf, der einen Kühlbereich 23 bildet und dem über eine Eintrittsöffnung 23a ein Kühlmedium 24, beispielsweise in Form von Kühlwasser, zugeführt werden kann. Wie in Fig. 2a ebenfalls zu erkennen ist, ist in dem Kühlbereich 23 ein erster Teilbereich 21a der Oberfläche des Fensters 21 angeordnet, welcher mit dem Kühlmedium 24 in Kontakt kommt. Der Kühlbereich 23 bildet einen im Wesentlichen ringförmigen Hohlraum und weist an einer der Eintrittsöffnung 23a diametral gegenüber liegenden Seite eine Austrittsöffnung 23b auf, um das Kühlmedium 24 abzuführen. Die Zuführung des Kühlmediums 24 erfolgt bei dem in Fig. 2a gezeigten Beispiel über eine Zuführungsleitung 26, die von einer Kühleinrichtung (Kühlaggregat) 25 ausgeht. Das an der Austrittsöffnung 23b des Kühlbereichs 23 austretende, erwärmte Kühlmedium 24 wird über eine Abführungsleitung 27 der Kühleinrichtung 25 zugeführt, welche die vom Kühlmedium 24 aufgenommene Wärme an die Umgebung oder an ein anderes Medium abgibt. Die Kühleinrichtung 25, die Zuführungsleitung 26 sowie die Abführungsleitung 27 bilden einen geschlossenen Kühlkreislauf für das Kühlmedium 24. Es versteht sich, dass dies nicht zwingend der Fall ist, d.h. das erwärmte Kühlmedium 24 kann - beispielsweise bei der Verwendung von Kühlwasser- an die Umgebung abgegeben werden.

Die Einrichtung 20 weist zusätzlich eine Unterdruckerzeugungseinrichtung in Form einer Venturi-Düse 28 auf. Der Venturi-Düse 28 wird über eine Versorgungsleitung 29 ein flüssiges Druckmedium zugeführt, das einem nicht gezeigten Reservoir entnommen wird. Die Venturi-Düse 28 weist ein Abnehmerrohr 28a auf, in dem das durch die Venturi-Düse 28 strömende Druckmedium einen Unterdruck erzeugt. Das Abnehmerrohr 28a steht über eine Verbindungsleitung 30 mit einem in der Fassung 22 des Fensters 21 gebildeten Unterdruckbereich 31 in Verbindung, der im gezeigten Beispiel als Hohlraum ausgebildet ist. Der Unterdruckbereich 31 ist im Bereich des Fensters 21 kreisringförmig ausgebildet, so dass ein zweiter, ringförmiger Teilbereich 21b des Fensters 21, genauer gesagt von dessen Oberfläche, sich in dem Unterdruckbereich 31 befindet und mit einem Unterdruck p_{U} beaufschlagt ist, der beispielsweise nur geringfügig unter dem Atmosphärendruck (1013 mbar) liegen kann. Zum gasdichten Abtrennen des Unterdruckbereichs 31 von dem Kühlbereich 23 ist in der Fassung 22 eine erste Dichtung 32a in Form eines O-Rings angebracht. Zur gasdichten Abtrennung des Unterdruckbereichs 31 von der Strahlführungs-Kammer 3 ist in der Fassung 22 eine zweite Dichtung 32b in Form eines weiteren O-Rings angebracht.

Der Unterdruck p_{U} in dem Unterdruckbereich 31 wird mit Hilfe einer Detektionseinrichtung überwacht, die im gezeigten Beispiel als Drucksensor 33 ausgebildet ist. Der Drucksensor 33 dient dazu, beim Überschreiten eines vorgegebenen Schwellwerts p_{S} des Unterdrucks p_{U} (p_{U} > p_{S}) oder beim Überschreiten eines vorgegebenen Schwellwerts Δp_{S} eines Anstiegs Δp_{U} des Drucks p_{U} (pro Zeiteinheit) ein Überströmen des Kühlmediums 24 von dem Kühlbereich 23 in den Unterdruckbereich 31 zu detektieren, das bei einer Beschädigung, z.B. bei einer Rissbildung, an dem Fenster 21 auftreten kann. In Fig. 2a ist der Fall dargestellt, dass beim Überschreiten des Schwellwerts Δp_{S} des Druckanstiegs Δp_{U} die Einrichtung 20 von einem Kühlbetrieb in einen Spülbetrieb umschaltet, der in Fig. 2b dargestellt ist.

Alternativ oder zusätzlich zur Detektion des Übertritts des Kühlmediums 24 von dem Kühlbereich 23 in den Unterdruckbereich 31 kann auch eine Detektion des Übertritts des Kühlmediums 24 in die Vakuum-Umgebung 4a erfolgen. Die ist beispielsweise mittels eines mit der Vakuum-Umgebung 4a verbundenen Drucksensors 37 (vgl. Fig. 1) möglich, der zur Bestimmung des Betriebsdrucks p₂ in der Vakuum-Kammer 4 dient. Liegt der Betriebsdruck p₂ in der Vakuum-Kammer 4 über einem Druck-Schwellwert p_{2,S}, wird ein Überströmen des Kühlmediums 24 in die Vakuum-Umgebung 4a detektiert und die Einrichtung 20 vom Kühlbetrieb in den Spülbetrieb umgeschaltet. Alternativ oder zusätzlich kann auch beim Überschreiten eines Schwellwerts Δp_{2,S} für den Druckanstieg Δp₂ des Betriebsdrucks p₂ in der Vakuum-Umgebung 4a die Einrichtung 20 vom Kühlbetrieb in den Spülbetrieb umgeschaltet werden.

Zusätzlich oder alternativ kann auch ein in Fig. 1 dargestellter Restgasanalysator 38 als Detektionseinrichtung verwendet werden. Der Restgasanalysator 38 ist zur Analyse der in der Vakuum-Umgebung 4a vorhandenen Restgasatmosphäre ausgebildet und ermöglicht eine quantitative Bestimmung des Partialdrucks bzw. der Anzahl an Molekülen der in der Restgasatmosphäre enthaltenen gasförmigen Stoffe. Im vorliegenden Fall dient der Restgasanalysator 38 dazu, den Partialdruck p_{H2O} des Kühlmediums 24 in Form von Kühlwasser, genauer gesagt von Wasserdampf, in der Restgasatmosphäre bzw. in der Vakuum-Umgebung 4a zu bestimmen.

Liegt der Partialdruck p_{H2O} des Kühlmediums 24 über einem Schwellwert p_{H2O,S}, so wird die Einrichtung 20 vom Kühlbetrieb in den Spülbetrieb umgeschaltet. Alternativ oder zusätzlich kann auch beim Überschreiten eines Schwellwerts Δp_{H2O,S} für den Druckanstieg Δp_{H2O} des Partialdrucks p_{H2O} des Kühlmediums 24 in der Vakuum-Umgebung 4a die Einrichtung 20 vom Kühlbetrieb in den Spülbetrieb umgeschaltet werden. Letzteres ist insbesondere günstig, wenn auch ohne den Übertritt des Kühlmediums 24 aus dem Kühlbereich 23 bereits eine geringe Menge des Kühlmediums 24 in der Vakuum-Umgebung 4a vorhanden ist. Typischer Weise ist in der Vakuum-Umgebung 4a eine geringe Menge an Wasserdampf vorhanden, so dass bei der Verwendung von Wasser als Kühlmedium 24 die Detektion der Leckage anhand des Vergleichs des Druckanstiegs Δp_{H2O} mit einem Schwellwert Δp_{H2O} ggf. günstiger ist als die Detektion anhand des Vergleichs des Partialdrucks p_{H2O} mit einem Schwellwert p_{H2O,S}.

Zum Umschalten vom Kühlbetrieb in den Spülbetrieb wirkt der Drucksensor 33, der weitere Drucksensor 37 und/oder der Restgasanalysator 38 direkt oder ggf. über eine Steuereinrichtung auf zwei schaltbare Ventile 34a, 34b ein. Hierbei wird das erste Ventil 34a, welches als Wegeventil mit zwei Schaltstellungen ausgebildet ist, von einer ersten, in Fig. 2a gezeigten Schaltstellung, in welcher die Zuführungsleitung 26 für das Kühlmedium 24 mit der Eintrittsöffnung 23a des Kühlbereichs 23 verbunden ist, in eine zweite, in Fig. 2b gezeigte Schaltstellung umgeschaltet, in der die Verbindung zwischen der Zuführungsleitung 26 und der Eintrittsöffnung 23a getrennt ist und die Eintrittsöffnung 23a stattdessen mit der Verbindungsleitung 30 zwischen dem Ansaugrohr 28a der Venturi-Düse 28 und dem Unterdruckbereich 31 verbunden wird. Gleichzeitig wird auch das zweite Ventil 34b von einer dritten Schaltstellung (vgl. Fig. 2a) in eine erste Schaltstellung (vgl. Fig. 2b) umgeschaltet, in der die Abführungsleitung 27 für das Kühlmedium 24 von der Austrittsöffnung 23b getrennt ist. Auf diese Weise wird die Kühleinrichtung 25 bzw. der Kühlkreislauf 25, 26, 27 vollständig von der optischen Komponente 21 getrennt.

In der in Fig. 2b gezeigten dritten Schaltstellung des zweiten Ventils 34b wird gleichzeitig eine Zuführungsleitung 35 für ein Spülmedium 36 mit der Austrittsöffnung 23b des Kühlbereichs 23 verbunden. Bei dem Spülmedium 36 handelt es sich um ein Edelgas, beispielsweise Argon, oder ggf. um Wasserstoff. Das Spülmedium 36 wird aus einem nicht bildlich dargestellten Reservoir entnommen, in dem das Spülmedium 36 unter Druck aufbewahrt wird. Das über die Austrittsöffnung 23b in den Kühlbereich 23 eingeleitete Spülmedium 36 verdrängt das Kühlmedium 24, welches durch die Eintrittsöffnung 23a aus dem Kühlbereich 23 austritt. Die Eintrittsöffnung 23a ist in der in Fig. 2b gezeigten zweiten Schaltstellung des ersten Ventils 34a mit der Verbindungsleitung 30 und somit mit der Venturi-Düse 28 verbunden, über die das Kühlmedium 24 und auch das Spülmedium 36 abgesaugt wird. Das abgesaugte Kühlmedium 24 und auch das abgesaugte Spülmedium 36 gelangen über das Abnehmerrohr 28a in die Venturi-Düse 28, werden von dem in der Venturi-Düse 28 strömenden Druckfluid mitgeführt und können ggf. aufgefangen werden. Mit Hilfe der Venturi-Düse 28 können auch Restmoleküle des Kühlmediums 24 abgesaugt werden, die noch in den Leitungsabschnitten zwischen der Eintrittsöffnung 23a des Kühlbereichs 23 bzw. zwischen einer Eintrittsöffnung 31a des Unterdruckbereichs 31 und der Venturi-Düse 28 verblieben sind.

Ist der Spülvorgang abgeschlossen, kann die Einrichtung 20 in einen Ruhebetrieb umgeschaltet werden, in dem das zweite Ventil 34b seine zweite Schaltstellung einnimmt, in welcher die Austrittsöffnung 23b vollständig gesperrt ist, so dass kein Spülmedium 36 mehr in den Kühlbereich 23 und in den Unterdruckbereich 31 gelangt. Zusätzlich kann die Versorgungsleitung 29 der Venturi-Düse 28 gesperrt werden, so dass die Venturi-Düse 28 keinen Unterdruck p_{U} mehr erzeugt. In dem auf diese Weise hergestellten Ruhebetrieb kann das beschädigte Fenster 21 aus der Fassung 22 entnommen und durch ein neues Fenster ersetzt werden.

Das neue Fenster schließt den Unterdruckbereich 31 gasdicht von dem Kühlbereich 23 ab, so dass die Einrichtung 20 erneut im Kühlbetrieb betrieben werden kann. Die Schaltung des zweiten Ventils 34b in die zweite Schaltstellung kann automatisch nach einem vorgegebenen Zeitraum erfolgen, der ggf. von einem Verzögerungsglied bzw. einer Verzögerungsschaltung vorgegeben wird. Es versteht sich, dass die Schaltung der Ventile 34a, 34b nicht zwingend von der Detektionseinrichtung bzw. dem Drucksensor 33 vorgenommen werden muss, sondern dass ggf. eine zusätzliche Steuereinrichtung in der Einrichtung 20 vorgesehen werden kann, der das von dem Drucksensor 33 gelieferte Messsignal übermittelt wird und die in Abhängigkeit von dem gemessenen Unterdruck p_{U} die Schaltung der Ventile 34a, 34b bzw. die Umschaltung zwischen dem Kühlbetrieb, dem Spülbetrieb und dem Ruhebetrieb vornimmt. Es versteht sich, dass an Stelle von zwei steuerbaren Ventilen 34a, 34b nur ein einziges steuerbares Ventil in der Einrichtung 20 vorgesehen werden kann. Im gezeigten Beispiel ist das erste steuerbare Ventil 34a federbeaufschlagt, so dass dieses ohne das Anlegen einer Spannung bzw. der Beaufschlagung mit Strom die in Fig. 2a gezeigte Schaltstellung (Kühlbetrieb) einnimmt..

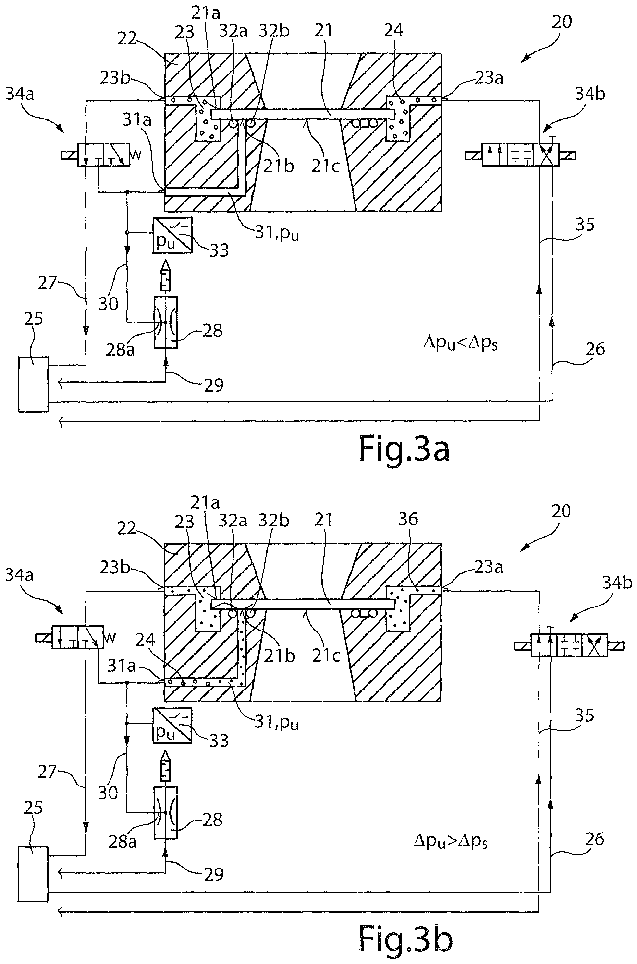

**Fig. 3a,b** zeigen ein Ausführungsbeispiel, bei dem die Strömungsrichtung des Kühlmediums 25 in dem Kühlkreislauf 25, 26, 27 gegenüber der in Fig. 2a,b gezeigten Ausführungsform umgekehrt ist. Entsprechend ist die Rolle der Eintrittsöffnung 23a und der Austrittsöffnung 23b vertauscht. Das zweite Ventil 34b ist daher zur wahlweisen Verbindung der Eintrittsöffnung 23a mit der Zuführungsleitung 26 für das Kühlmedium 24 oder mit der Zuführungsleitung 35 für das Spülmedium 36 ausgebildet. Entsprechend ist das erste schaltbare Ventil 34a zum wahlweisen Verbinden einer Auslassöffnung 23b des Kühlbereichs 23 mit einer Abführungsleitung 27 für das Kühlmedium 24 oder mit einer Verbindungsleitung 30 zur Verbindung mit der Unterdruckerzeugungseinrichtung 28 ausgebildet. Gegebenenfalls kann die Zuführung und Abführung des Spülmediums 36 nicht über die Eintrittsöffnung 23a bzw. die Austrittsöffnung 23b (oder umgekehrt), sondern über zusätzliche Öffnungen erfolgen.

Zusammenfassend kann auf die oben beschriebene Weise ein wirksamer Schutz einer Vakuum-Umgebung 4a vor dem Eindringen eines Kühlmediums 24 bei einer Leckage an einer optischen Komponente 21 realisiert werden, welche die Vakuum-Umgebung 4a gasdicht abschließt. Es versteht sich, dass die optische Komponente nicht zwingend als Fenster 21 ausgebildet sein muss sondern ggf. auch als Linse oder in anderer Weise ausgebildet sein kann. Auch dient die optische Komponente 21 nicht zwingend zur Trennung der Vakuum-Kammer 4 von der Strahlführungs-Kammer 3, wie dies in Fig. 1 gezeigt ist, da zwischen der Vakuum-Kammer 4 und der Strahlführungs-Kammer 3 ggf. eine (nicht gezeigte) Zwischen-Kammer angeordnet sein kann.

## Patentansprüche

1. Einrichtung (20) zum Schutz einer Vakuum-Umgebung (4a) vor Leckage, umfassend:
eine optische Komponente (21) zum gasdichten Abschluss der Vakuum-Umgebung (4a),
eine Kühleinrichtung (25) zum Kühlen der optischen Komponente (21) durch Zuführen eines Kühlmediums (24) zu einem gasdicht von der Vakuum-Umgebung (4a) getrennten Kühlbereich (23), in dem ein erster Teilbereich (21a) der optischen Komponente (21) angeordnet ist,
**gekennzeichnet durch** eine Unterdruckerzeugungseinrichtung (28) zur Erzeugung eines Unterdrucks (p_{U}) in einem gasdicht von der Vakuum-Umgebung (4a) und
von dem Kühlbereich (23) getrennten Unterdruckbereich (31), in dem ein zweiter Teilbereich (21b) der optischen Komponente (21) angeordnet ist, sowie durch eine Detektionseinrichtung (33, 37, 38) zur Detektion einer Leckage an der optischen Komponente (21) beim Überströmen des Kühlmediums (24) von dem Kühlbereich (23) in den Unterdruckbereich (31) und/oder in die Vakuum-Umgebung (4a).

2. Einrichtung nach Anspruch 1, welche ausgebildet ist, bei einer Leckage an der optischen Komponente (21) eine Zuführungsleitung (26) zur Zuführung des Kühlmediums (24) zu dem Kühlbereich (23) zu sperren.

3. Einrichtung nach Anspruch 2, welche ausgebildet ist, bei einer Leckage an der optischen Komponente (21) dem Kühlbereich (23) ein Spülmedium (36) zuzuführen.

4. Einrichtung nach Anspruch 3, welche ausgebildet ist, dem Kühlbereich (23) das Spülmedium (36) über eine Austrittsöffnung (23b) oder über eine Eintrittsöffnung (23a) für das Kühlmedium (24) zuzuführen.

5. Einrichtung nach Anspruch 4, welche entweder ein schaltbares Ventil (34b) zur wahlweisen Verbindung der Austrittsöffnung (23b) mit einer Zuführungsleitung (35) für das Spülmedium (36) oder einer Abführungsleitung (27) für das Kühlmedium (24) aufweist oder ein schaltbares Ventil (34b) zur wahlweisen Verbindung der Eintrittsöffnung (23a) mit einer Zuführungsleitung (26) für das Kühlmedium (24) oder mit einer Zuführungsleitung (35) für das Spülmedium (36) aufweist.

6. Einrichtung nach einem der Ansprüche 3 bis 5, welche ausgebildet ist, zur Absaugung des Spülmediums (36) aus dem Kühlbereich (23) eine Fluidverbindung zwischen dem Kühlbereich (23) und der Unterdruckerzeugungseinrichtung (28) herzustellen.

7. Einrichtung nach Anspruch 6, welche entweder ein schaltbares Ventil (34a) zum wahlweisen Verbinden einer Einlassöffnung (23a) des Kühlbereichs (23) mit einer Zuführungsleitung (26) für das Kühlmedium (24) oder mit einer Verbindungsleitung (30) zur Verbindung mit der Unterdruckerzeugungseinrichtung (28) aufweist oder ein schaltbares Ventil (34a) zum wahlweisen Verbinden einer Auslassöffnung (23a) des Kühlbereichs (23) mit einer Abführungsleitung (27) für das Kühlmedium (24) oder mit einer Verbindungsleitung (30) zur Verbindung mit der Unterdruckerzeugungseinrichtung (28) aufweist.

8. Einrichtung nach einem der vorhergehenden Ansprüche, bei welcher die Detektionseinrichtung einen Drucksensor (33) zur Bestimmung eines von der Unterdruckerzeugungseinrichtung (28) erzeugten Unterdrucks (p_{U}) und/oder einen Drucksensor (37) zur Bestimmung eines Drucks (p₂) in der Vakuum-Umgebung (4a) aufweist, wobei die Detektionseinrichtung (33, 37) bevorzugt ausgebildet ist, beim Überschreiten eines Schwellwerts des Unterdrucks (p_{U}) und/oder des Drucks (p₂) in der Vakuum-Umgebung (4a) oder beim Überschreiten eines Schwellwerts (Δp_{S}) eines Druckanstiegs (Δp_{U}) des Unterdrucks (p_{U}) und/oder des Drucks (p₂) in der Vakuum-Umgebung (4a) ein Überströmen des Kühlmediums (24) von dem Kühlbereich (23) in den Unterdruckbereich (31) und/oder in die Vakuum-Umgebung (4a) zu detektieren.

9. Einrichtung nach einem der vorhergehenden Ansprüche, bei welcher die Detektionseinrichtung einen Restgasanalysator (38) zur Detektion des Kühlmediums (24) in der Vakuum-Umgebung (4a) aufweist, wobei der Restgasanalysator (38) bevorzugt ausgebildet ist, beim Überschreiten eines Schwellwerts für den Partialdruck (p_{H2O}) des Kühlmediums (24) in der Vakuum-Umgebung (4a) oder beim Überschreiten eines Schwellwerts eines Anstiegs des Partialdrucks (p_{H2O}) des Kühlmediums (24) in der Vakuum-Umgebung (4a) ein Überströmen des Kühlmediums (24) von dem Kühlbereich (23) in die Vakuum-Umgebung (4a) zu detektieren.

10. Einrichtung nach einem der vorhergehenden Ansprüche, weiter umfassend: eine Halteeinrichtung (22) zur Halterung der optischen Komponente (21), in welcher der Kühlbereich (23) und der Unterdruckbereich (31) gebildet sind.

11. Einrichtung nach einem der vorhergehenden Ansprüche, weiter umfassend:
mindestens eine Dichtung (32a) zur gasdichten Trennung des Kühlbereichs (23) vom Unterdruckbereich (31).

12. Einrichtung nach einem der vorhergehenden Ansprüche, bei welcher die optische Komponente (21) einen optisch genutzten Teilbereich (21c) aufweist und der erste Teilbereich (21a) weiter von dem optisch genutzten Teilbereich (21c) entfernt ist als der zweite Teilbereich (21b).

13. EUV-Strahlungserzeugungsvorrichtung (1), umfassend:
eine Vakuum-Kammer (4) mit einer Vakuum-Umgebung (4a), in der zur Erzeugung von EUV-Strahlung (14) ein Target-Material (13) anordenbar ist, sowie eine Einrichtung (20) nach einem der vorhergehenden Ansprüche.

14. Verfahren zum Schutz einer Vakuum-Umgebung (4a) vor einer Leckage an einer optischen Komponente (21), welche die Vakuum-Umgebung (4a) gasdicht abschließt,
umfassend die Schritte:
Zuführen eines Kühlmediums (24) zu einem gasdicht von der Vakuum-Umgebung (4a) getrennten Kühlbereich (23), in dem ein erster Teilbereich (21a) der optischen Komponente (21) angeordnet ist,
**gekennzeichnet durch**
Erzeugen eines Unterdrucks (p_{U}) in einem gasdicht von der Vakuum-Umgebung (4a) und von dem Kühlbereich (23) getrennten Unterdruckbereich (31), in dem ein zweiter Teilbereich (21b) der optischen Komponente (21) angeordnet ist, sowie Detektieren einer Leckage an der optischen Komponente (21) beim Überströmen des Kühlmediums (24) von dem Kühlbereich (23) in den Unterdruckbereich (31) und/oder in die Vakuum-Umgebung (4a).

15. Verfahren nach Anspruch 14, bei dem nach dem Detektieren der Leckage das Zuführen des Kühlmediums (24) zu dem Kühlbereich (23) unterbunden wird und/oder dem Kühlbereich (23) ein Spülmedium (36) zugeführt wird, wobei bevorzugt zum Absaugen des Spülmediums (36) aus dem Kühlbereich (23) eine Fluidverbindung zwischen dem Kühlbereich (23) und einer Unterdruckerzeugungseinrichtung (28) hergestellt wird.

## Claims

1. Device (20) for protecting a vacuum environment (4a) from leakage, comprising:
an optical component (21) for the gas-tight closure of the vacuum environment (4a),
a cooling device (25) for cooling the optical component (21) by supplying a cooling medium (24) to a cooling region (23) which is separated from the vacuum environment (4a) in a gas-tight manner and in which a first part-region (21a) of the optical component (21) is arranged,
**characterized by**
a reduced-pressure production device (28) for producing a reduced pressure (pᵤ) in a reduced-pressure region (31) which is separated in a gas-tight manner from the vacuum environment (4a) and from the cooling region (23) and in which a second part-region (21b) of the optical component (21) is arranged, and by
a detection device (33, 37, 38) for detecting a leakage in the optical component (21) when the cooling medium (24) flows from the cooling region (23) into the reduced-pressure region (31) and/or into the vacuum environment (4a).

2. Device according to claim 1, which is adapted, in the event of a leakage in the optical component (21), to block a supply line (26) for supplying the cooling medium (24) to the cooling region (23).

3. Device according to claim 2, which is adapted, in the event of a leakage in the optical component (21), to supply a flushing medium (36) to the cooling region (23).

4. Device according to claim 3, which is adapted to supply the flushing medium (36) to the cooling region (23) via an outlet opening (23b) or via an inlet opening (23a) for the cooling medium (24).

5. Device according to claim 4, which has either a switchable valve (34b) for selectively connecting the outlet opening (23b) to a supply line (35) for the flushing medium (36) or to a discharge line (27) for the cooling medium (24), or
a switchable valve (34b) for selectively connecting the inlet opening (23a) to a supply line (26) for the cooling medium (24) or to a supply line (35) for the flushing medium (36).

6. Device according to any one of claims 3 to 5, which is adapted, in order to draw the flushing medium (36) from the cooling region (23), to produce a fluid connection between the cooling region (23) and the reduced-pressure production device (28).

7. Device according to claim 6, which has either a switchable valve (34a) for selectively connecting an inlet opening (23a) of the cooling region (23) to a supply line (26) for the cooling medium (24) or to a connection line (30) for connection to the reduced-pressure production device (28), or a switchable valve (34a) for selectively connecting an outlet opening (23b) of the cooling region (23) to a discharge line (27) for the cooling medium (24) or to a connection line (30) for connection to the reduced-pressure production device (28).

8. Device according to any one of the preceding claims, in which the detection device has a pressure sensor (33) for determining a reduced pressure (pᵤ) produced by the reduced-pressure production device (28) and/or a pressure sensor (37) for determining a pressure (p₂) in the vacuum environment (4a), wherein the detection device (33, 37) is preferably adapted, when a threshold value of the reduced pressure (pᵤ) and/or the pressure (p₂) in the vacuum environment (4a) is exceeded or when a threshold value (Δpₛ) of a pressure increase (Δpᵤ) of the reduced pressure (pᵤ) and/or the pressure (p₂) in the vacuum environment (4a) is exceeded, to detect a flow of the cooling medium (24) from the cooling region (23) into the reduced-pressure region (31) and/or into the vacuum environment (4a).

9. Device according to any one of the preceding claims, in which the detection device has a residual gas analyser (38) for detecting the cooling medium (24) in the vacuum environment (4a), wherein the residual gas analyser (38) is preferably constructed, when a threshold value for the partial pressure (p_{H2O}) of the cooling medium (24) in the vacuum environment (4a) is exceeded or when a threshold value of an increase of the partial pressure (p_{H2O}) of the cooling medium (24) in the vacuum environment (4a) is exceeded, to detect a flow of the cooling medium (24) from the cooling region (23) into the vacuum environment (4a).

10. Device according to any one of the preceding claims, further comprising: a retention device (22) for retaining the optical component (21) in which the cooling region (23) and the reduced-pressure region (31) are formed.

11. Device according to any one of the preceding claims, further comprising: at least one seal (32a) for separating the cooling region (23) from the reduced-pressure region (31) in a gas-tight manner.

12. Device according to any one of the preceding claims, in which the optical component (21) has an optically used part-region (21c) and the first part-region (21a) is further away from the optically used part-region (21c) than the second part-region (21b).

13. EUV radiation production device (1), comprising:
a vacuum chamber (4) having a vacuum environment (4a) in which a target material (13) can be arranged in order to produce EUV radiation (14), and a device (20) according to any one of the preceding claims.

14. Method for protecting a vacuum environment (4a) from a leakage in an optical component (21), which closes the vacuum environment (4a) in a gas-tight manner,
comprising the steps of:
supplying a cooling medium (24) to a cooling region (23) which is separated from the vacuum environment (4a) in a gas-tight manner and
in which a first part-region (21a) of the optical component (21) is arranged, **characterized by**
producing a reduced pressure (pᵤ) in a reduced-pressure region (31) which is separated from the vacuum environment (4a) and from the cooling region (23) in a gas-tight manner and in which a second part-region (21b) of the optical component (21) is arranged, and
detecting a leakage in the optical component (21) when the cooling medium (24) flows from the cooling region (23) into the reduced-pressure region (31) and/or into the vacuum environment (4a).

15. Method according to claim 14, in which, after the detection of the leakage, the supply of the cooling medium (24) to the cooling region (23) is prevented and/or a flushing medium (36) is supplied to the cooling region (23), wherein a fluid connection is preferably produced between the cooling region (23) and a reduced-pressure production device (28) in order to draw off the flushing medium (36) from the cooling region (23).

## Revendications

1. Dispositif (20) destiné à protéger un environnement sous vide (4a) contre les fuites, comprenant :
un composant optique (21) destiné à fermer l'environnement sous vide (4a) de manière étanche aux gaz,
un dispositif de refroidissement (25) destiné à refroidir le composant optique (21) par amenée d'un milieu de refroidissement (24) à une zone de refroidissement (23) qui est isolée de manière étanche aux gaz de l'environnement sous vide (4a) et dans laquelle est disposée une première zone partielle (21a) du composant optique (21),
**caractérisé par** un dispositif de production de dépression (28) destiné à produire une dépression (p_{U}) dans une zone de dépression (31) qui est isolée de manière étanche aux gaz de l'environnement sous vide (4a) et de la zone de refroidissement (23) et dans laquelle est disposée une deuxième zone partielle (21b) du composant optique (21), ainsi que par un dispositif de détection (33, 37, 38) destiné à détecter une fuite sur le composant optique (21) en cas de débordement du milieu de refroidissement (24) de la zone de refroidissement (23) dans la zone de dépression (31) et/ou dans l'environnement sous vide (4a).

2. Dispositif selon la revendication 1, lequel est conçu, en cas de fuite sur le composant optique (21), pour couper une conduite d'amenée (26) destinée à amener le milieu de refroidissement (24) à la zone de refroidissement (23).

3. Dispositif selon la revendication 2, lequel est conçu, en cas de fuite sur le composant optique (21), pour amener un milieu de rinçage (36) à la zone de refroidissement (23).

4. Dispositif selon la revendication 3, lequel est conçu pour amener le milieu de rinçage (36) à la zone de refroidissement (23) par une ouverture de sortie (23b) ou par une ouverture d'entrée (23a) pour le milieu de refroidissement (24).

5. Dispositif selon la revendication 4, lequel présente soit une soupape commutable (34b) destinée à relier au choix l'ouverture de sortie (23b) à une conduite d'amenée (35) pour le milieu de rinçage (36) ou à une conduite d'évacuation (27) pour le milieu de refroidissement (24), soit une soupape commutable (34b) destinée à relier au choix l'ouverture d'entrée (23a) à une conduite d'amenée (26) pour le milieu de refroidissement (24) ou à une conduite d'amenée (35) pour le milieu de rinçage (36).

6. Dispositif selon l'une des revendications 3 à 5, lequel est conçu, afin d'aspirer le milieu de rinçage (36) de la zone de refroidissement (23), pour établir une liaison fluidique entre la zone de refroidissement (23) et le dispositif de production de dépression (28).

7. Dispositif selon la revendication 6, lequel présente soit une soupape commutable (34a) destinée à relier au choix une ouverture d'entrée (23a) de la zone de refroidissement (23) à une conduite d'amenée (26) pour le milieu de refroidissement (24) ou à une conduite de raccordement (30) pour la liaison avec le dispositif de production de dépression (28), soit une soupape commutable (34a) destinée à relier au choix une ouverture de sortie (23a) de la zone de refroidissement (23) à une conduite d'évacuation (27) pour le milieu de refroidissement (24) ou à une conduite de raccordement (30) pour la liaison avec le dispositif de production de dépression (28).

8. Dispositif selon l'une des revendications précédentes, dans lequel le dispositif de détection présente un capteur de pression (33) destiné à déterminer une dépression (p_{U}) produite par le dispositif de production de dépression (28) et/ou un capteur de pression (37) destiné à déterminer une pression (p₂) dans l'environnement sous vide (4a), dans lequel le dispositif de détection (33, 37) est de préférence conçu pour détecter un débordement du milieu de refroidissement (24) de la zone de refroidissement (23) dans la zone de dépression (31) et/ou dans l'environnement sous vide (4a) en cas de dépassement d'une valeur seuil de la dépression (p_{U}) et/ou de la pression (p₂) dans l'environnement sous vide (4a) ou en cas de dépassement d'une valeur seuil (Δp_{S}) d'une augmentation de pression (Δp_{U}) de la dépression (p_{U}) et/ou de la pression (p₂) dans l'environnement sous vide (4a).

9. Dispositif selon l'une des revendications précédentes, dans lequel le dispositif de détection présente un analyseur de gaz résiduel (38) destiné à détecter le milieu de refroidissement (24) dans l'environnement sous vide (4a), dans lequel l'analyseur de gaz résiduel (38) est de préférence conçu pour détecter un débordement du milieu de refroidissement (24) de la zone de refroidissement (23) dans l'environnement sous vide (4a) en cas de dépassement d'une valeur seuil de la pression partielle (P_{H2O}) du milieu de refroidissement (24) dans l'environnement sous vide (4a) ou en cas de dépassement d'une valeur seuil d'une augmentation de la pression partielle (P_{H2O}) du milieu de refroidissement (24) dans l'environnement sous vide (4a).

10. Dispositif selon l'une des revendications précédentes, comprenant en outre : un dispositif de maintien (22) pour maintenir le composant optique (21), dans lequel la zone de refroidissement (23) et la zone de dépression (31) sont formées.

11. Dispositif selon l'une des revendications précédentes, comprenant en outre : au moins un joint (32a) destiné à isoler de manière étanche aux gaz la zone de refroidissement (23) de la zone de dépression (31).

12. Dispositif selon l'une des revendications précédentes, dans lequel le composant optique (21) présente une zone partielle (21c) utilisée optiquement et la première zone partielle (21a) est plus éloignée de la zone partielle (21c) utilisée optiquement que la deuxième zone partielle (21b).

13. Dispositif de production de rayonnement EUV (1), comprenant :
une chambre à vide (4) avec un environnement sous vide (4a), dans laquelle peut être disposé un matériau cible (13) pour la production d'un rayonnement EUV (14),
ainsi qu'un dispositif (20) selon l'une des revendications précédentes.

14. Procédé destiné à protéger un environnement sous vide (4a) d'une fuite sur un composant optique (21) qui ferme l'environnement sous vide (4a) de manière étanche aux gaz,
comprenant l'étape consistant à :
amener un milieu de refroidissement (24) à une zone de refroidissement (23) isolée de manière étanche aux gaz de l'environnement sous vide (4a), dans laquelle est disposée une première zone partielle (21a) du composant optique (21),
**caractérisé par** les étapes consistant à :
produire une dépression (p_{U}) dans une zone de dépression (31) isolée de manière étanche aux gaz de l'environnement sous vide (4a) et de la zone de refroidissement (23), dans laquelle est disposée une deuxième zone partielle (21b) du composant optique (21), et
détecter une fuite sur le composant optique (21) en cas de débordement du milieu de refroidissement (24) de la zone de refroidissement (23) dans la zone de dépression (31) et/ou dans l'environnement sous vide (4a).

15. Procédé selon la revendication 14, dans lequel, après la détection de la fuite, l'amenée du milieu de refroidissement (24) à la zone de refroidissement (23) est empêchée et/ou un milieu de rinçage (36) est amené à la zone de refroidissement (23), dans lequel, de préférence, afin d'aspirer le milieu de rinçage (36) de la zone de refroidissement (23), une liaison fluidique est établie entre la zone de refroidissement (23) et un dispositif de production de dépression (28).
